# EUROPEAN PATENT SPECIFICATION

(11) **EP 3 330 930 B1**
(45) Date of publication and mention of the grant of the patent: **23.03.2022**
(21) Application number: 17205114.6
(22) Date of filing: 04.12.2017
(51) Int. Cl.: G07C 5/00, H05K 1/18, H05K 5/00

(54) **A TELEMATICS DEVICE FOR A VEHICLE**
TELEMATIKVORRICHTUNG FÜR EIN FAHRZEUG
DISPOSITIF TÉLÉMATIQUE POUR VÉHICULE

(30) Priority: 05.12.2016 GB 201620636
(43) Date of publication of application: 06.06.2018
(73) Proprietor: Trakm8 Ltd, Shaftesbury, Dorset SP7 9QJ (GB)
(72) Inventor: COWLEY, Timothy, Shaftesbury, Dorset SP7 9QJ (GB); JEWELL, Paul, Shaftesbury, Dorset SP7 9QJ (GB)
(74) Representative: Script IP Limited

(56) References cited:
- EP-A1- 2 701 368
- US-A1- 2008 257 006
- US-A1- 2010 270 923
- US-A1- 2013 246 135

## Description

### FIELD OF THE INVENTION

The invention relates to telematics devices or boxes for mounting in a vehicle connected to the vehicle's on-board diagnostic system.

### BACKGROUND

Many modern vehicles have complex diagnostic systems that allow for both the engine functionality and the driver's behaviour to be analysed. Many vehicles contain a multitude of sensors for sensing the engine's operation. The parameters sensed may include different variables such as acceleration, deceleration, temperature and noise. These sensors send their readings along a CAN (control area network) bus to an on-board diagnostic (OBD) socket. When servicing a vehicle, monitoring equipment can be connected to the OBD socket and readings from the various sensors taken.

The presence of this OBD socket also allows for this data to be accessed during vehicle use as well as in a garage situation. The data provided by these sensors during use provides an indication of both driver behaviour and engine functionality and there may be advantages to being able to monitor this continually and to transmit collected data to a remote analyser using a wireless communication system.

In addition to the data collected from vehicle mounted sensors, it may be advantageous to collect further data relevant to the vehicle use that can be sent along with the data collected from the on-board diagnostic system. A GPS antenna for example, that is able to collect GPS data would allow information about the location of the vehicle and journeys taken to be collected.

Although the collection of data during use may be advantageous, it requires a telematics device or box to be fitted to the OBD socket for the collection and transmission of this data. It is desirable for such a box to be small and discrete, so that it can be attached to an OBD socket located somewhere in the vehicle without extending unduly into the useful space of the vehicle.

The desire for the box to be small and discrete competes with the desire for it to provide increasingly complex circuitry for monitoring and transmitting increasing amounts and diversity of data. Furthermore, where cellular wireless communication capabilities are provided then an antenna of a reasonable size is required, given that such communication frequencies may be as low as 800MHZ. Such an antenna will also need to have some protection from interference from signals from other circuitry within the box.

Conventionally the circuitry of such telematics boxes has been mounted on printed circuit boards which are themselves mounted to form a stack within a housing. Such a format requires individual circuit boards to be manufactured, connected together and mounted within the housing. Furthermore, it is difficult with such a construction to mount an antenna of a suitable size for wireless communications at a position where interference from other circuitry is not too great.

EP2701368 discloses a wireless device with an antenna and having two printed circuit boards. One of the boards has an exothermic component and needs to be electrically connected to the other board but thermally isolated from it to some degree. A flexible circuit board is used to connect the two PCBs.

It would be desirable to provide a telematics box which is compact and has reduced manufacturing costs.

### SUMMARY

The present invention provides a telematics device for attaching to a vehicle's on-board diagnostic system, said telematics device comprising:
a flexible circuit board mounted within a housing and comprising a first, a second and an intermediate portion, said first, second and intermediate portions being rigid portions and being linked by flexible portions between them, forming one single piece which can be folded;
said flexible circuit board comprising a conductive layer forming a ground plane, said flexible circuit board being folded within said housing such that at least a part of said first portion overlies at least a part of said second portion, said conductive layer extending across said first, second and intermediate portions; wherein
one of said portions further comprises an extension part extending beyond at least one of said first, intermediate and second portions and having an antenna mounted proximate to a far end of said extension part; and
said first portion comprises, mounted on an outward facing side facing away from said second portion, a connector for connecting to said diagnostic connector on said vehicle;
said second portion comprises, mounted on an outward facing side facing away from said first portion, a GPS antenna for receiving signals from GPS satellite; and
said telematics device further comprises a power source, said power source being mounted between said first portion and said second portion. The invention is defined by the appended independent claim 1, preferred features are set out in the dependent claims. Embodiments not falling within the scope of the claims are provided for illustration purposes only.

Telematics devices have conventionally addressed the requirement of a high number of components or devices in a small space by mounting the components on printed circuit boards and stacking the printed circuit boards with the housing. However, the manufacture and stacking of separate circuit boards is relatively complex and therefore costly. This has been addressed by the inventor of the present invention by the use of a flexible circuit board which is folded within the housing, such that the first and second portion at least partly overlie each other, forming an arrangement which has similarities to a stack, but with an additional intermediate section which can itself carry components. Furthermore, the use of a single circuit board, albeit a flexible one, makes for easier manufacture. The problem of mounting the antenna within the confined space is addressed by one of the portions having an extension part, with the antenna being mounted proximate to, that is at or towards, the far end of the extension part such that the antenna is remote from at least some of the components.

In some embodiments, each of said first, intermediate and second portions comprise an electrical component mounting part, each electrical component mounting part having at least one electrical component mounted thereon; and said extension part extending beyond said electrical component part such that said antenna is mounted at or towards an end of said extension part remote from said electrical component mounting part. Each portion may have an electrical component mounting part, with the extension part extending beyond this and thus, holding the antenna away from this part of the electrical components. An electrical component may be an electronic component, it may be an antenna, and it may be some form of active or passive device.

In some embodiments, said portion comprising said extension part is longer than the other portions by a length of said extension part.

It may be advantageous if the first, second and intermediate portions each have similar lengths with the extension part extending beyond these portions. In this way, the antenna is mounted remotely from the components mounted on all of the portions.

In some embodiments said extension part is at least 10mm in length.

A distance of at least 10mm between the antenna and other components within the telematics box has been found to be a good compromise between providing a compact device and reducing interference between circuitry within the telematics box and the antenna.

In some embodiments, said antenna is an antenna suitable for receiving and transmitting cellular wireless communication signals.

Where the antenna is an antenna for receiving and transmitting cellular wireless communication signals, then these signals may be between 800MHz and 3GHz and thus the antenna will have to have a reasonable size. Mounting it on an extension part away from the other components of the device not only reduces interference effects, but also provides a part of the housing exclusively for the antenna allowing it to have a relatively large size.

In some embodiments, said antenna is mounted substantially perpendicular to at least one of said first, second and intermediate portions.

The antenna is mounted substantially perpendicular to at least one of the intermediate portions and in some embodiments to all of the first, second and intermediate portions. Mounting the antenna in this way allows it to have the full cross sectional area of the housing. Furthermore, being perpendicular to much of the circuitry allows at least one lobe from the antenna to extend away from this circuitry and away from any power source mounted within the telematics box.

In this regard the antenna may have a number of forms, but in some embodiments it may comprise a conductive pattern mounted on a non-conductive board, the non-conductive board having a cross sectional area that is 80% or more of the cross sectional area of the housing.

In some embodiments, said first and second portions are substantially parallel to each other and said intermediate portion is substantially perpendicular to both said first and second portion.

Providing a folded circuit board provides for a compact shape which fits well within a housing, this is particularly so where the first and second portions are substantially perpendicular to the intermediate portion and form a U type shape. It should be noted that angles between 70 and 110 degrees are deemed to be substantially perpendicular for the sake of this patent application.

Said first portion comprises, mounted on an outward facing side facing away from said second portion, a connector for connecting to a diagnostic connector on said vehicle.

One of the portions will carry a connector for connecting to a diagnostic connector on the vehicle and this should point outwards from the telematics device such that the device can be connected to the vehicle.

In some embodiments, said first portion comprises said extension part and said connector extends along at least a portion of said extension part.

The connector may be on the portion that comprises the extension part. The size of the connector is dependent on the size of the OBD socket and thus, where it is mounted on a portion of the flexible circuit board it provides a lower limit to the size of this portion. Mounting it on the portion that has the extension part means that the smallest size of the longest portion is governed by the size of the connector, and this allows for a smaller telematics box than were the connector to be mounted on one of the portions that does not comprise an extended part.

Said second portion comprises, mounted on an outward facing side facing away from said first portion, a GPS antenna for receiving signals from GPS satellite.

The GPS antenna receiving signals from GPS satellites is a useful addition to a telematics device allowing information regarding the location of a vehicle and any journeys undertaken to be derived. However, GPS signals are weak and difficult to detect and thus in order for the GPS antenna to be in a convenient position for detecting such signals, it is advantageous if it is mounted on a side of the circuit board facing outwards away from the rest of the circuit board. Thus, , the connector is mounted on one outward facing portion and the GPS antenna on the other outward facing portion meaning that when the component is connected to the vehicle, the GPS antenna is facing away from the vehicle connector and away from the interior of the telematics box.

In some embodiments, said at least one component comprises at least one of a modem, a GPS antenna, a processor, a data store, an accelerometer, a gyro sensor and a Bluetooth module.

The components on the telematics device may comprise a number of things including a modem for wireless communications, a GPS antenna as mentioned before, processors, data stores, an accelerometer, a gyro sensor, a Bluetooth or other short distance wireless communication module and other circuitry, such as a power supply.

In some embodiments, said first portion comprises said modem mounted on an inward facing side facing towards said second portion.

The modem requires significant power but does not require sight of signals received from outside of the telematics box. Thus, it may be advantageous if it is mounted on an inward facing side so that outward facing sides are available for other components. It is particularly advantageous if it is mounted on the inward facing side of the portion supporting the connector as that allows power from the vehicle to be supplied simply and directly to the modem.

Said telematics device further comprises a local power source, said local power source being mounted between said first portion and said second portion.

Although the telematics device can receive power from the vehicle, it is advantageous if it also has a local power source allowing it to transmit and/or monitor signals when it is not receiving power from the vehicle, perhaps while the vehicle is not in use. Mounting the power source between the first and second portion allows the first and second portion to be separated from each other. Furthermore, in this position the outward facing lobes from both the GPS antenna and the cellular wireless communication antenna point away from the power source. Additionally, in the case of the GPS antenna there is a circuit board between it and the power source, which where the circuit board has a conductive layer or ground plate further shields the antenna from the power source. The local power source may be a battery, or it may be a capacitor. The capacitor may have a large capacitance and be configured to be charged when the vehicle is in operation and the telematics device receives power from the vehicle. The capacitor can then provide power to the telematics device by slowly discharging when the vehicle is not operational.

In some embodiments, said flexible circuit board comprises at least one conductive layer attached to at least one non-conductive sheet, said flexible circuity board comprising at least two flexible portions and at least three portions with a greater rigidity, said first, second and intermediate portions comprising said three more rigid portions.

The flexible circuit board comprises a conductive sheet which with appropriate mounting of components and antenna provides shielding between them. In particular, by using a flexible circuit board, the ground plane formed by the conductive layer extends across the portions providing an increased size of ground plane when compared to separate stacked circuit boards and thereby providing improved shielding. The first, second and intermediate portions which are used for mounting the components are rigid with flexible portions between them allowing the circuit board to be folded.

Although the portions of the circuit board can in some embodiments have components only mounted on one side, it is advantageous if they have components mounted on both sides as this provides a further improvement in the spatial efficiency of the device.

Where an apparatus feature is described as being operable to provide a function, it will be appreciated that this includes an apparatus feature which provides that function or which is adapted or configured to provide that function.

### BRIEF DESCRIPTION OF THE DRAWINGS

Embodiments of the present invention will now be described further, with reference to the accompanying drawings, in which:
Figure 1 shows a telematics device according to an embodiment;
Figure 2 shows one side of a flexible circuit board with components of the telematics device mounted thereon according to an embodiment;
Figure 3 shows the other side of the flexible circuit board shown in Figure 2;
Figure 4 shows an antenna that is mounted on an extended portion of the flexible circuit board; and
Figure 5 schematically shows a cross-section through a telematics device with the lobes of the GPS antenna and cellular antenna schematically shown.

### DESCRIPTION OF THE EMBODIMENTS

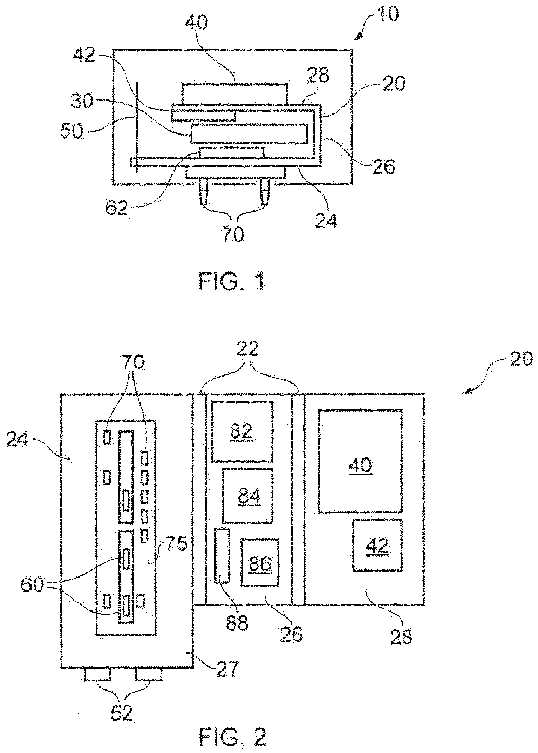

Figure 1 schematically shows a cross-section through a telematics device according to an embodiment. The telematics device is mounted within housing 10 and comprises a flexible circuit board 20 which is folded to form a U shape. The flexible circuit board 20 is formed of non-conductive layers sandwiching at least one conductive layer that has had conductive tracks etched in it. In some embodiments there may be plural layers which allow for better shielding and provide more connection possibilities.

One portion of the flexible circuit board 20 has an extended part on which is mounted antenna 50 for transmitting and receiving cellular wireless communication signals. By mounting the antenna on the extended part, it is distanced from many of the components that are mounted on the flexible circuit board and also from battery 30 that supplies power to components of the flexible circuit board 20 when the vehicle to which the telematics device is connected is not operational. Furthermore, antenna 50 is mounted substantially perpendicular to the flexible circuit board and this allows the main lobe of the antenna to extend outwards from the housing and away from the telematics circuitry

The portion of the flexible circuit board on which the antenna 50 is mounted is first portion 24 and this comprises on an outer surface on which is mounted connector pins 70 for connecting to the OBD socket on the vehicle. On the opposite of the first portion of the flexible circuit board 20 is component 62 of the telematics device, which in this embodiment comprises a modem. By mounting the modem on the reverse side of the flexible circuit board to the connector pins 70, proximity to the power supplied from the vehicle is provided, which is important as the modem is a power hungry component. Furthermore, the modem when mounted here does not take up an outer surface, leaving the outer surfaces of the flexible circuit board 20 available for components such as antennas which transmit and receive signals.

Flexible circuit board 20 is folded within housing 10 such that a second portion 28 overlies the first portion 24 and has intermediate portion 26 between the two portions. Mounted between these first and second portions is battery 30 that supplies power to the various components mounted on the circuit board when the vehicle is not operational.

On the outer surface of the second portion 28 there is GPS antenna 40 which detects and receives GPS signals. By mounting it facing away from the connector, it has sight away from the vehicle and is therefore better able to pick up GPS signals which can be weak signals that are difficult to detect.

As can be seen, this arrangement provides a compact design with a small footprint, with the components mounted in a spatially efficient way. The use of a single printed circuit board that is flexible and folded to provide multiple component mounting surfaces provides manufacturing simplicity requiring only a single circuit board. Such an arrangement also provides a conductive plane that travels around the components and around a centrally mounted battery providing improved electrical shielding. In particular, the conductive plane provides shielding of the GPS antenna from the battery. In some embodiments the battery may be replaced by a large capacitor and it is advantageous if this is shielded from components such as the GPS antenna.

Furthermore, the mounting of the GPS antenna on an outer surface opposite to the OBD connector, and the mounting of the wireless communication antenna at one end of and perpendicular to the first portion, provides an arrangement which allows the main lobes from these antennas to extend outward away from the telematics device and away from the vehicle to which the telematics device is attached in use. There will of course be other lobes travelling the other way but the main lobes will have good sight of signals received from the vehicle exterior.

Figure 2 shows one side of flexible circuit board 20 in a non-folded state. The side shown is the outer side when folded. In this embodiment, flexible circuit board 20 has a first portion 24 with an extended part 27 which extends beyond the other portions of the flexible circuit board and holds antenna mounting pegs 52. The first portion 24 of flexible circuit board 20 comprises a connector pin mounting board 75 which is non-conductive and robust and mounts the connecting pins 70 which are configured to connect with an OBD socket on the vehicle and allow signals and power from the OBD socket to reach the components of the telematics device.

In this regard, modern vehicles have sensors for sensing operational conditions of the vehicle such as temperature, acceleration and deceleration. Signals from these sensors are transmitted via a CAN bus to the OBD socket where they can be output for analysis when, for example, the vehicle is being serviced. The signals can also be collected when the vehicle is operational by plugging a telematics device into this socket. Such a device should be compact so as not to impede a driver's movement. Each connector pin 70 mates with a different socket on the OBD socket and receives different signals and/or power. The connector pin mounting board 75 has in some embodiments a space in the middle and this space may be used for mounting further telematics components 60 on the flexible printed circuit board 20.

First portion 24 is a rigid portion on which the connector pins 70 and other telematics devices are mounted. First portion 24 is connected to intermediate portion 26 via flexible portion 22. This flexible portion 22 allows the printed circuit board to be folded. The flexible portion 22 comprises conductive tracks for connecting components on different portions. There are components mounted on the intermediate portion 26 and these may include processor 82, memory 84, an accelerometer 86 and a gyro 88. In this regard, in addition to the sensors mounted on the vehicle, additional sensors may be mounted within the telematics device to provide additional data that may be helpful when assessing both driver behaviour and vehicle operational conditions. A gyro to detect movement in all of three dimensions may be useful as may an accelerometer to detect changes in movement of the vehicle such as may occur when a driver enters the vehicle or the vehicle impacts another vehicle or impacts irregularities in a driving surface.

Intermediate portion 26 is connected via another flexible portion 22 to a second portion 28. When the flexible circuit board is folded within the telematics device housing then second portion 28 overlies first portion 24 with intermediate portion 26 being substantially perpendicular to both portions. Battery 30 is then housed between the portions. The surface of second portion 28 that is shown in this figure will face away from the connecting pins 70 when the component is folded and is used to mount a GPS antenna 40 which therefore faces away from the vehicle and away from the telematics device itself. This allows it to have sight of the exterior of the vehicle and to detect signals received from GPS satellites. In addition to a GPS antenna, there is GPS circuitry 42 for analysing the signals received by the GPS antenna 40 and determining the location of the vehicle.

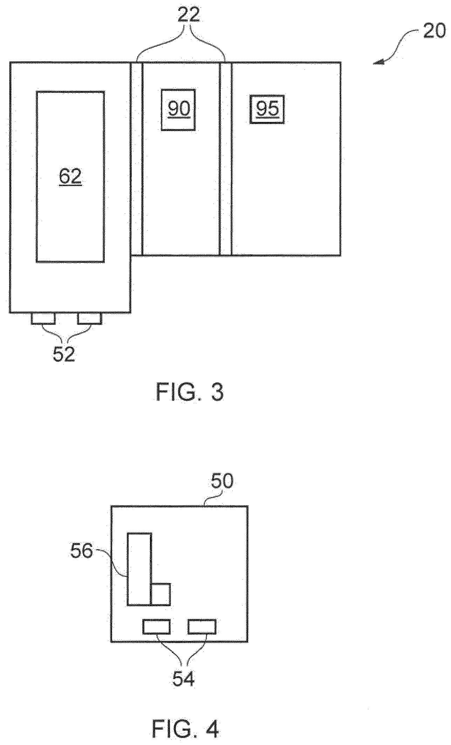

Figure 3 shows the other surface of flexible circuit board 20 comprising a first portion 24, second portion 28 and intermediate portion 26, these portions being joined together by flexible portions 22. Mounted on first portion 24 is modem 62 which consumes a relatively large amount of power and as such is mounted close to connecting pins 70 so as to have easy access to the power supplied from the vehicle. Power supply circuitry 90 is mounted on intermediate portion 26. In this embodiment, there is also a Bluetooth chip 95 mounted on second portion 28. It should be clear to a skilled person that these are only examples of the different components and examples of where they may be mounted. Components and their position on the flexible circuit board may differ depending on the nature and functional requirements of the particular telematics device and the size and shape of the different components. In general, however, it is desirable for the connecting pins and GPS antenna to be mounted on a same outward facing side of the flexible circuit board and on different portions.

Figure 4 schematically shows antenna 50. Antenna 50 comprises mounting apertures 54 which cooperate with the pegs 52 from the extended portion 27 of first portion 24. These hold the antenna in position and also provide conductive connections to the antenna. The antenna 50 is designed for cellular communication such as GSM (Global Systems for Mobile Communications) and comprises a flat plane with a conductive pattern 56 printed on it. The conductive pattern forms a resonant structure for receiving and transmitting the cellular signals. Owing to the wavelength and frequency of such signals, which may be at frequencies as low as 800MHz, this antenna needs to have a reasonable size. Furthermore, it should be located relatively remotely from the components within the telematics device. Mounting it at an end of an extended portion distances the antenna from the other portions and from the components mounted thereon. Furthermore, by mounting the antenna substantially perpendicularly to each of the portions of the flexible circuit board 20 and by providing a pattern to generate a lobe that points outwardly, a component that efficiently transmits and receives wireless communication signals is provided. These signals comprise data received or detected at the telematics box and are transmitted using cellular communications to a remote analysing device which can store and/or analyse this information.

It should be noted that in some cases there may also be some form of more local wireless communication provided perhaps by a Bluetooth module and/or other near field communication module. Such a module allows signals from the telematics box to be transmitted locally, perhaps to a mobile phone of the driver, when the phone is located within the vehicle. The mobile phone can then transmit these signals to the remote analysing component and/or transmit information to the driver regarding the vehicle condition and/or his driving behaviour. In this way the need for the telematics device to have cellular wireless communication capabilities may be reduced or even avoided.

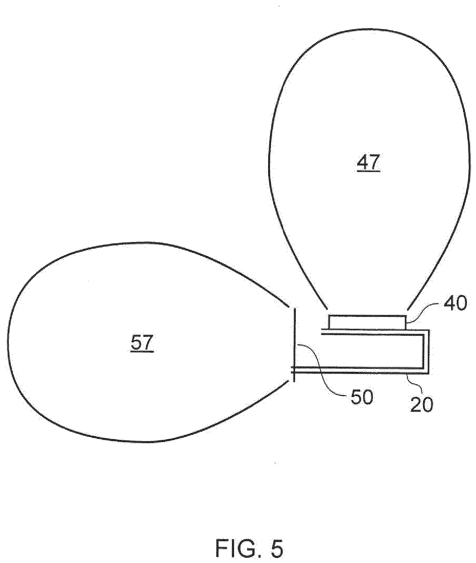

Figure 5 schematically shows the lobes extending from the antennas 40, 50 mounted on flexible circuit board 20. As can be seen the main lobes (shown) extend away from the other components of the telematics device and away from the connector which is connected to the vehicle. Lobe 57 extends from antenna 50 whereas lobe 47 extends from GPS antenna 40. The GPS antenna may be a ceramic antenna and is adapted to detect low power GPS signals.

In summary, a telematics device which has a small footprint, can receive signals from an OBD socket on a vehicle and can in some embodiments detect GPS signals and receive and transmit GSM signals is provided.

The components of this device are mounted on a flexible circuit board 20 which is then mounted in a folded state within a housing. The flexible circuit board provides for ease of manufacture when compared to a device formed from a stack of circuit boards. The conductive ground plate of the flexible circuit board also provides shielding and in particular shielding of the battery from the lobes of the antenna. The arrangement also provides a particularly compact and spatially efficient arrangement.

## Claims

1. A telematics device (10) for attaching to a vehicle's on-board diagnostic system, said telematics device comprising:
a flexible circuit board (20) mounted within a housing and comprising a first (24), a second (28) and an intermediate portion (26); said first, second and intermediate portions being rigid portions and being linked by flexible portions between them, forming one single piece which can be folded;
said flexible circuit board comprising a conductive layer forming a ground plane, said flexible circuit board being folded within said housing such that at least a part of said first portion (24) overlies at least a part of said second portion (28), said conductive layer extending across said first, second and intermediate portions; wherein
one of said portions further comprises an extension part extending beyond at least one of said first, intermediate and second portions and having an antenna (50) mounted proximate to a far end of said extension part; and
said first portion (24) comprises, mounted on an outward facing side facing away from said second portion, a connector (70) for connecting to said diagnostic connector on said vehicle;
said second portion (28) comprises, mounted on an outward facing side facing away from said first portion, a GPS antenna (40) for receiving signals from GPS satellite; and
said telematics device further comprises a power source (50), said power source being mounted between said first portion and said second portion.

2. A telematics device according to claim 1, wherein each of said first, intermediate and second portions comprise an electrical component mounting part, each electrical component mounting part having at least one electrical component mounted thereon; said extension part extending beyond said electrical component part such that said antenna is mounted proximate to an end of said extension part (27) remote from said electrical component mounting part.

3. A telematics device according to claim 1 or 2, wherein said portion comprising said extension part is longer than the other portions by a length of said extension part.

4. A telematics device according to any preceding claim, wherein said antenna (50) is an antenna suitable for receiving and transmitting cellular wireless communication signals.

5. A telematics device according to any preceding claim, wherein said antenna (50) is mounted substantially perpendicular to at least one of said first, second and intermediate portions.

6. A telematics device according to any preceding claim, wherein said antenna comprises a conductive pattern on a non-conductive board.

7. A telematics device according to claim 6, wherein a cross section of said non-conductive board has an area of 80% or more of said cross sectional area of said housing.

8. A telematics device according to any preceding claim, wherein said first portion (24) comprises said extension part (27) and said connector (70) extends along at least a portion of said extension part.

9. A telematics device according to any preceding claim, wherein said telematics device comprises at least one electrical component, said at least one electrical component comprising at least one of a modem, a GPS antenna, a processor, a data store, an accelerometer, a gyro sensor, a Bluetooth module.

10. A telematics device according to any preceding claim, wherein said first portion (24) comprises a modem (62) mounted on an inward facing side facing towards said second portion.

11. A telematics device according to any preceding claim, wherein said conductive layer is attached to at least one non-conductive sheet, said flexible circuity board comprising at least two flexible portions and at least three portions with a greater rigidity, said first, second and intermediate portions comprising said three rigid portions.

12. A telematics device according to any preceding claim, wherein said first, second and intermediate portions each have component mounting surfaces on both sides of said circuit board.

## Patentansprüche

1. Telematikvorrichtung (10) zum Anbringen an das On-Board-Diagnosesystem eines Fahrzeugs, wobei die Telematikvorrichtung umfasst:eine flexible Leiterplatte (20), die in einem Gehäuse montiert ist und einen ersten (24), einen zweiten (28) und einen mittleren Abschnitt (26) umfasst; wobei der erste, der zweite und der mittlere Abschnitt starre Abschnitte sind und durch flexible Abschnitte dazwischen miteinander verknüpft sind, die ein einziges faltbares Stück bilden;
wobei die flexible Leiterplatte eine leitende Schicht umfasst, die eine Masseebene bildet, wobei die flexible Leiterplatte innerhalb des Gehäuses so gefaltet ist, dass mindestens ein Teil des ersten Abschnitts (24) über mindestens einem Teil des zweiten Abschnitts (28) liegt, wobei sich die leitende Schicht über den ersten, zweiten und mittleren Abschnitt erstreckt; wobei
einer der Abschnitte weiter ein Verlängerungsteil umfasst, das sich über mindestens einen der ersten, mittleren und zweiten Abschnitte hinaus erstreckt und eine Antenne (50) aufweist, die in der Nähe eines anderen Endes des Verlängerungsteils montiert ist; und
der erste Abschnitt (24), montiert auf einer nach außen weisenden Seite, die von dem zweiten Abschnitt abgewandt ist, einen Verbinder (70) zum Verbinden mit dem Diagnoseverbinder an dem Fahrzeug umfasst;
der zweite Abschnitt (28), montiert auf einer nach außen weisenden Seite, die von dem ersten Abschnitt abgewandt ist, eine GPS-Antenne (40) zum Empfangen von Signalen von GPS-Satelliten umfasst; und
die Telematikvorrichtung weiter eine Energiequelle (50) umfasst, wobei die Energiequelle zwischen dem ersten Abschnitt und dem zweiten Abschnitt montiert ist.

2. Telematikvorrichtung nach Anspruch 1, wobei der erste, der mittlere und der zweite Abschnitt jeweils ein Montageteil für eine elektrische Komponente umfassen, wobei an jedem Montageteil für eine elektrische Komponente mindestens eine elektrische Komponente montiert ist; wobei sich das Verlängerungsteil über die elektrische Komponente hinaus erstreckt, so dass die Antenne in der Nähe eines Endes des Verlängerungsteils (27) entfernt von dem Montageteil für die elektrische Komponente montiert ist.

3. Telematikvorrichtung nach Anspruch 1 oder 2, wobei der Abschnitt, der das Verlängerungsteil umfasst, um eine Länge des Verlängerungsteils länger ist als die anderen Abschnitte.

4. Telematikvorrichtung nach einem der vorstehenden Ansprüche, wobei die Antenne (50) eine Antenne ist, die zum Empfangen und Senden von zellularen drahtlosen Kommunikationssignalen geeignet ist.

5. Telematikvorrichtung nach einem der vorstehenden Ansprüche, wobei die Antenne (50) im Wesentlichen senkrecht zu mindestens einem der ersten, zweiten und mittleren Abschnitte montiert ist.

6. Telematikvorrichtung nach einem der vorstehenden Ansprüche, wobei die Antenne ein leitendes Muster auf einer nichtleitenden Platte umfasst.

7. Telematikvorrichtung nach Anspruch 6, wobei ein Querschnitt der nichtleitenden Platte eine Fläche von 80 % oder mehr der Querschnittsfläche des Gehäuses aufweist.

8. Telematikvorrichtung nach einem der vorstehenden Ansprüche, wobei der erste Abschnitt (24) das Verlängerungsteil (27) umfasst und der Verbinder (70) sich entlang mindestens eines Abschnitts des Verlängerungsteils erstreckt.

9. Telematikvorrichtung nach einem der vorstehenden Ansprüche, wobei die Telematikvorrichtung mindestens eine elektrische Komponente umfasst, wobei die mindestens eine elektrische Komponente mindestens eines der folgenden Elemente umfasst: ein Modem, eine GPS-Antenne, einen Prozessor, einen Datenspeicher, einen Beschleunigungsmesser, einen Gyrosensor, ein Bluetooth-Modul.

10. Telematikvorrichtung nach einem der vorstehenden Ansprüche, wobei der erste Abschnitt (24) ein Modem (62) umfasst, das an einer nach innen gerichteten Seite montiert ist, die dem zweiten Abschnitt zugewandt ist.

11. Telematikvorrichtung nach einem der vorstehenden Ansprüche, wobei die leitende Schicht an mindestens einer nichtleitenden Folie befestigt ist, wobei die flexible Leiterplatte mindestens zwei flexible Abschnitte und mindestens drei Abschnitte mit einer größeren Steifigkeit umfasst, wobei der erste, zweite und mittlere Abschnitt die drei starren Abschnitte umfassen.

12. Telematikvorrichtung nach einem der vorstehenden Ansprüche, wobei der erste, der zweite und der mittlere Abschnitt jeweils Komponentenmontageflächen auf beiden Seiten der Leiterplatte aufweisen.

## Revendications

1. Dispositif télématique (10) pour l'associer à un système de diagnostic à bord d'un véhicule, ledit système télématique comprenant :
un circuit imprimé flexible (20) monté dans un logement et comprenant une première (24), une seconde (28) et une portion intermédiaire (26) ; lesdites première, seconde portions et l'intermédiaire étant des portions rigides et étant liées par des portions flexibles entre elles, formant une pièce unique qui peut être pliée ;
ledit circuit imprimé flexible comprenant une couche conductrice formant un plan de masse, ledit circuit imprimé flexible étant plié dans ledit logement de sorte qu'au moins une partie de ladite première portion (24) recouvre au moins une partie de ladite seconde portion (28), ladite couche conductrice s'étendant sur lesdites première, seconde portions et ladite portion intermédiaire ; dans lequel
une desdites portions comprend en outre une partie d'extension s'étendant au-delà d'au moins une desdites première, intermédiaire et seconde portions et présentant une antenne (50) montée à proximité d'une extrémité éloignée de ladite partie d'extension ; et
ladite première portion (24) comprend, montée sur un côté tourné vers l'extérieur faisant face à distance à ladite seconde portion, un connecteur (70) pour se connecter audit connecteur de diagnostic sur ledit véhicule ;
ladite seconde portion (28) comprend, montée sur un côté tourné vers l'extérieur faisant face à distance à ladite première portion, une antenne GPS (40) pour recevoir des signaux d'un satellite GPS ; et
ledit dispositif télématique comprenant en outre une source d'alimentation (50), ladite source d'alimentation étant montée entre ladite première portion et ladite seconde portion.

2. Dispositif télématique selon la revendication 1, dans lequel chacune desdites première, intermédiaire et seconde portions comprend une partie de montage de composant électrique, chaque partie de montage de composant électrique présentant au moins un composant électrique monté sur celui-ci ; ladite partie d'extension s'étendant au-delà de ladite partie de composant électrique de sorte que ladite antenne est montée à proximité d'une extrémité de ladite partie d'extension (27) à distance de ladite partie de montage de composant électrique.

3. Dispositif télématique selon la revendication 1 ou 2, dans lequel ladite portion comprenant ladite partie d'extension est plus longue que les autres portions d'une longueur de ladite partie d'extension.

4. Dispositif télématique selon l'une quelconque des revendications précédentes, dans lequel ladite antenne (50) est une antenne convenant pour recevoir et transmettre des signaux de communication sans fil cellulaires.

5. Dispositif télématique selon l'une quelconque des revendications précédentes, dans lequel ladite antenne (50) est montée sensiblement perpendiculaire sur au moins ladite première et seconde portion et la portion intermédiaire.

6. Dispositif télématique selon l'une quelconque des revendications précédentes, dans lequel ladite antenne comprend un placage métallique sélectif sur un circuit non-conducteur.

7. Dispositif télématique selon la revendication 6, dans lequel une section transversale dudit circuit non-conducteur présente une zone de 80 % ou plus de ladite zone transversale dudit logement.

8. Dispositif télématique selon l'une quelconque des revendications précédentes, dans lequel ladite première portion (24) comprend ladite partie d'extension (27) et ledit connecteur (70) s'étend le long d'au moins une portion de ladite partie d'extension.

9. Dispositif télématique selon l'une quelconque des revendications précédentes, dans lequel ledit dispositif télématique comprend au moins un composant électrique, ledit au moins un composant électrique comprenant au moins un d'un modem, d'une antenne GPS, d'un processeur, d'une mémoire de données, d'un accéléromètre, d'un détecteur avec gyroscope, d'un module Bluetooth.

10. Dispositif télématique selon l'une quelconque des revendications précédentes, dans lequel ladite première portion (24) comprend un modem (62) monté sur un côté tourné vers l'intérieur faisant face à ladite seconde portion.

11. Dispositif télématique selon l'une quelconque des revendications précédentes, dans lequel ladite couche conductrice est attachée à au moins une tôle non-conductrice, ledit circuit imprimé flexible comprenant au moins deux portions flexibles et au moins trois portions avec une rigidité supérieure, lesdites première et seconde portions et la portion intermédiaire comprenant lesdites trois portions rigides.

12. Dispositif télématique selon l'une quelconque des revendications précédentes, dans lequel lesdites première et seconde portions et la portion intermédiaire présentent chacune des surfaces de montage de composant sur les deux côtés dudit circuit imprimé.
